# EUROPEAN PATENT SPECIFICATION

(11) **EP 3 916 782 B1**
(45) Date of publication and mention of the grant of the patent: **02.08.2023**
(21) Application number: 19911869.6
(22) Date of filing: 23.08.2019
(51) Int. Cl.: H01L 25/07, H01L 23/495, H01L 25/18, H02M 7/00, H02M 7/48, H01L 23/373, H01L 23/433

(54) **POWER SEMICONDUCTOR DEVICE**
LEISTUNGSHALBLEITERBAUELEMENT
DISPOSITIF À SEMI-CONDUCTEUR DE PUISSANCE

(30) Priority: 22.01.2019 JP 2019008189
(43) Date of publication of application: 01.12.2021
(73) Proprietor: Hitachi, Ltd., Tokyo 100-8280 (JP)
(72) Inventor: MOCHIZUKI, Masahito, Tokyo 100-8280 (JP); IDE, Eiichi, Tokyo 100-8280 (JP); NAGASAKI, Hironori, Tokyo 100-8280 (JP); TANAKA, Shintaro, Tokyo 100-8280 (JP); HIRAO, Takashi, Tokyo 100-8280 (JP); KUSUKAWA, Junpei, Tokyo 100-8280 (JP); TSUYUNO, Nobutake, Tokyo 100-8280 (JP)
(74) Representative: Mewburn Ellis LLP
(86) International application number: PCT/JP2019/032960
(87) International publication number: WO 2020/152898

(56) References cited:
- JP-A- 2006 040 926
- JP-A- 2007 215 396
- JP-A- 2010 205 960
- JP-A- 2013 162 019
- JP-A- 2016 195 179
- JP-B2- 3 841 007
- US-A1- 2018 122 720

## Description

### Technical Field

The present invention relates to a power semiconductor device, and more particularly to a power semiconductor device used in a power conversion device that converts DC power to AC power.

### Background Art

An inverter market for EVs is rapidly growing all over the world against the backdrop of enhancement of environmental regulations. On the other hand, inverters for high carrier frequency drive such as an SiC have attracted attention, and a low inductance structure is required to realize the high carrier frequency drive.

In a power semiconductor device described in PTL 1, a power semiconductor element section and a capacitor are arranged on the same surface of a negative electrode conductor portion and a positive electrode conductor portion. Thus, it is necessary to adjust the thickness of the capacitor to the thickness of the power semiconductor element section, which reduces the degree of freedom in design, and there is a limit to a size of the capacitor and the number of capacitors that can be used per power semiconductor device.

### Citation List

### Patent Literature

PTL 1: JP 2003-289219 A
Prior art is also disclosed in documents US2018/0122720 A1 and JP2010 205960 A.

### Summary of Invention

### Technical Problem

An object of the present invention is to reduce a wiring inductance of a power semiconductor device including a smoothing capacitor and achieve miniaturization. Solution to Problem

A power semiconductor device according to the present invention includes: a power semiconductor circuit section; a plurality of smoothing capacitors; a positive electrode conductor portion and a negative electrode conductor portion connecting the power semiconductor circuit section and the plurality of smoothing capacitors; and a sealing material that seals the power semiconductor circuit section, the plurality of smoothing capacitors, the positive electrode conductor portion, and the negative electrode conductor portion. The plurality of smoothing capacitors form a capacitor circuit section sandwiched between the positive electrode conductor portion and the negative electrode conductor portion. The power semiconductor circuit section has a first exposure surface exposed from the sealing material and a second exposure surface that is exposed from the sealing material and provided on a side opposite to the first exposure surface. A plane with which the first exposure surface overlaps is defined as a first plane, and a plane with which the second exposure surface overlaps is defined as a second plane. The capacitor circuit section is formed so as to fit in a space between the first plane and the second plane. The positive electrode conductor portion or the negative electrode conductor portion forms a concave portion to accommodate a part of each of the plurality of smoothing capacitors.

### Advantageous Effects of Invention

According to the present invention, it is possible to achieve the miniaturization of the power semiconductor device including the smoothing capacitor while reducing the wiring inductance.

### Brief Description of Drawings

[FIG. 1(a)] FIG. 1(a) is an overall perspective view of a power semiconductor device 1 according to the present embodiment as viewed from one side.
[FIG. 1(b)] FIG. 1(b) is an overall perspective view of the power semiconductor device 1 according to the present embodiment as viewed from the other side.
[FIG. 2(a)] FIG. 2(a) is a circuit diagram of the power semiconductor device 1 according to the present embodiment.
[FIG. 2(b)] FIG. 2(b) is a circuit diagram of a power conversion device using the power semiconductor device 1 according to the present embodiment.
[FIG. 3] FIG. 3 is a perspective plan view of the power semiconductor device 1 illustrating an arrangement of power semiconductor elements and capacitors 14 obtained by removing a sealing member 13 and an emitter-side ceramic substrate 36 and being seen through a positive electrode conductor portion 31 and a negative electrode conductor portion 32.
[FIG. 4] FIG. 4 is a cross-sectional view of the power semiconductor device 1 as viewed from an arrow direction a with respect to a plane S1 of FIG. 1(a).
[FIG. 5] FIG. 5 is a cross-sectional view of the power semiconductor device 1 as viewed from an arrow direction b with respect to a plane S2 of FIG. 1(a).
[FIG. 6] FIG. 6 is a cross-sectional view of a power semiconductor device according to another embodiment.
[FIG. 7] FIG. 7 is a perspective view illustrating a modification when the plurality of capacitors 14 are accommodated in concave portions 41 formed in the positive electrode conductor portion 31.
[FIG. 8] FIG. 8 is an overall perspective view of a 6-in-1 power semiconductor device formed by combining the 2-in-1 power semiconductor devices 1 illustrated in FIGS. 1 to 7.
[FIG. 9(a)] FIG. 9(a) is a cross-sectional view illustrating a manufacturing process of the power semiconductor device 1.
[FIG. 9(b)] FIG. 9(b) is a cross-sectional view illustrating the manufacturing process of the power semiconductor device 1.
[FIG. 9(c)] FIG. 9(c) is a cross-sectional view illustrating the manufacturing process of the power semiconductor device 1.
[FIG. 9(d)] FIG. 9(d) is a cross-sectional view illustrating the manufacturing process of the power semiconductor device 1.

### Description of Embodiments

Hereinafter, a power semiconductor device used in a power conversion device mounted on a vehicle will be described as an embodiment of a structure according to the present invention. A description will be given regarding a power semiconductor element, a conductor portion on which the power semiconductor element is mounted, and a ceramic substrate as an insulating resin plate electrically connected to the conductor plate with reference to the drawings. Incidentally, the same elements will be denoted by the same reference signs in the respective drawings, and the redundant description thereof will be omitted.

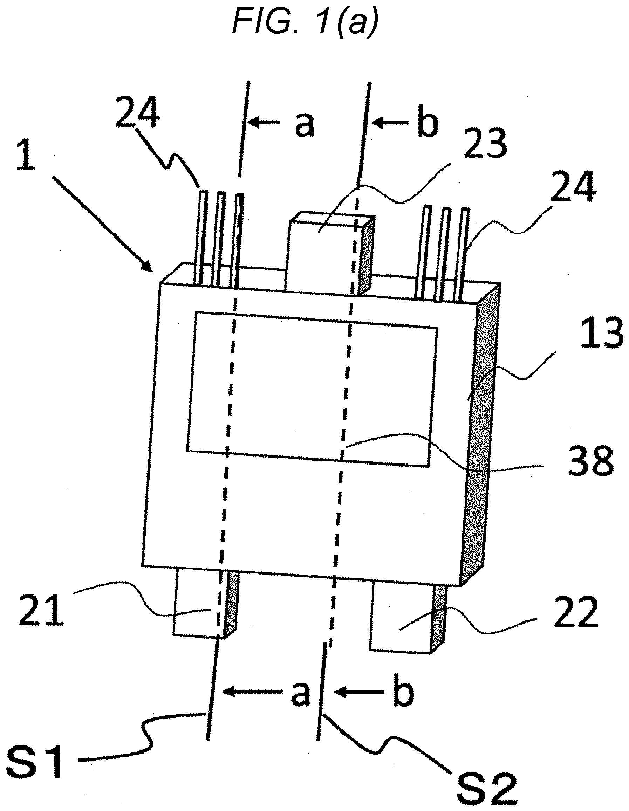

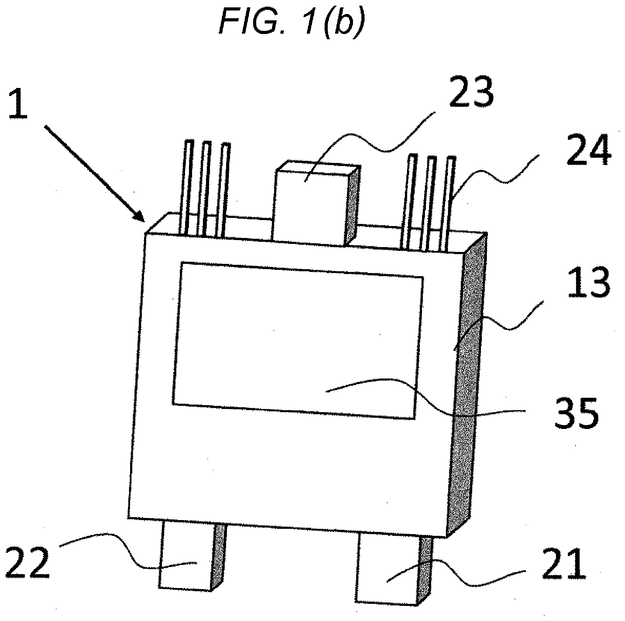

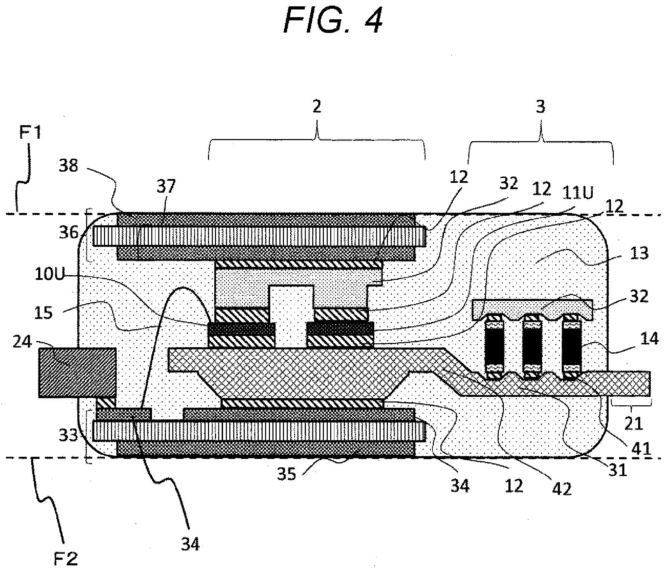

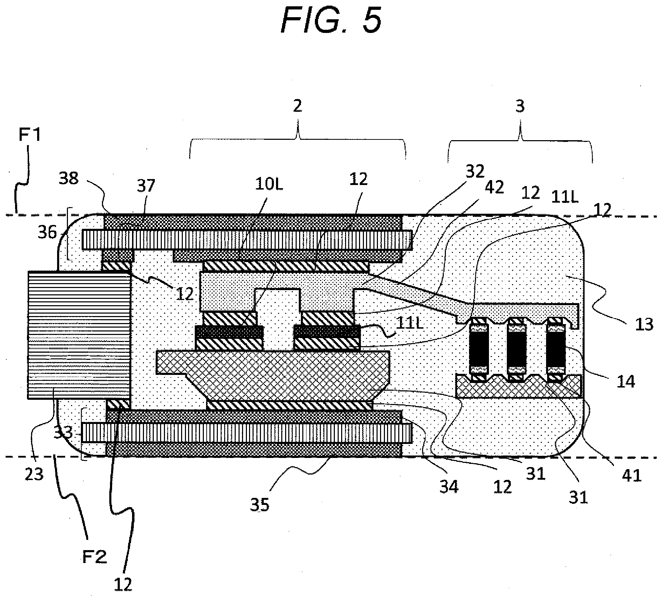

FIG. 1(a) is an overall perspective view of a power semiconductor device 1 according to the present embodiment as viewed from one side. FIG. 1(b) is an overall perspective view of the power semiconductor device 1 according to the present embodiment as viewed from the other side. FIG. 4 is a cross-sectional view of the power semiconductor device 1 as viewed from an arrow direction a with respect to a plane S1 of FIG. 1(a) . FIG. 5 is a cross-sectional view of the power semiconductor device 1 as viewed from an arrow direction b with respect to a plane S2 of FIG. 1(a).

The power semiconductor device 1 includes: a positive electrode terminal 21 and a negative electrode terminal 22 to which a DC voltage is applied; an AC output terminal 23 from which an AC voltage is output; and a control terminal 24 which transmits a control signal to control power semiconductor elements.

The power semiconductor elements include an upper arm IGBT 10U and an upper arm diode 11U illustrated in FIG. 4, and a lower arm IGBT 10L and a lower arm diode 11L illustrated in FIG. 5.

As illustrated in FIGS. 4 and 5, the sealing member 13 seals the power semiconductor elements, a positive electrode conductor portion 31, a negative electrode conductor portion 32, a collector-side ceramic substrate 33, an emitter-side ceramic substrate 36, and capacitors 14. The sealing member 13 is made of an insulating resin or the like.

As illustrated in FIG. 1(a), the positive electrode terminal 21 and the negative electrode terminal 22 protrude in the same direction from one side surface of the sealing member 13. The AC output terminal 23 and the control terminal 24 protrude in the same direction from the other side surface opposite to the one side surface of the sealing member 13.

As illustrated in FIG. 1(a), a metallized portion 38 of the emitter-side ceramic substrate 36 is exposed from a main surface of the sealing member 13. As illustrated in FIG. 1(b), a metallized portion 35 of the collector-side ceramic substrate 33 is exposed from the main surface of the sealing member 13.

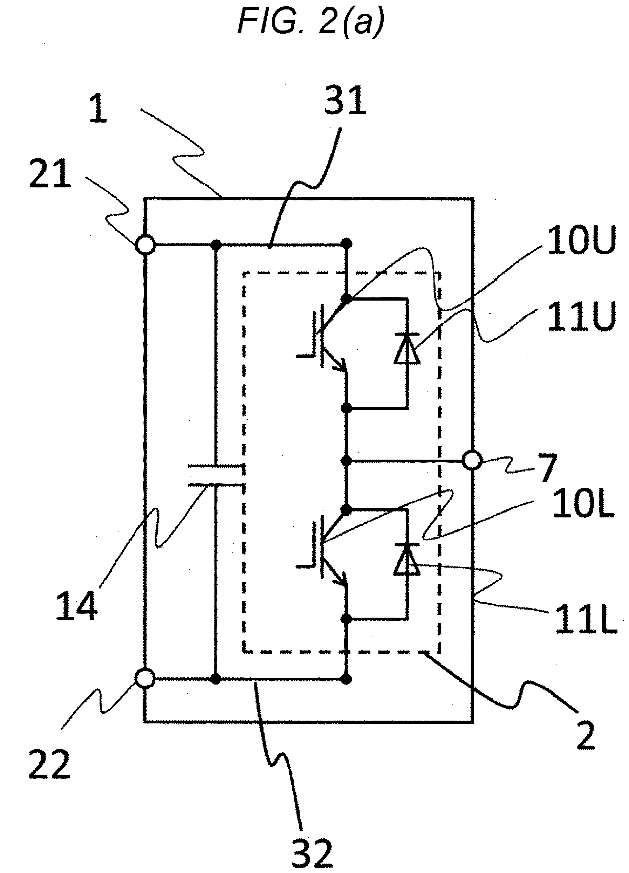

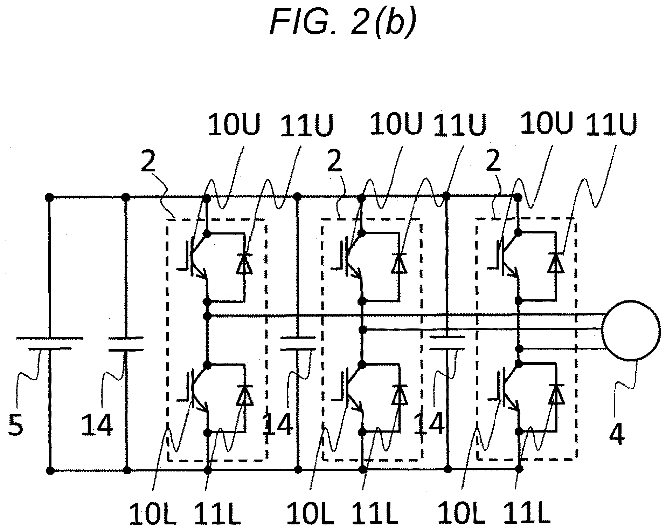

FIG. 2(a) is a circuit diagram of the power semiconductor device 1 according to the present embodiment. FIG. 2(b) is a circuit diagram of a power conversion device using the power semiconductor device 1 according to the present embodiment.

The positive electrode conductor portion 31 is connected to a positive electrode side of a battery 5 and the capacitor 14 via the positive electrode terminal 21. The negative electrode terminal portion 32 is connected to a negative electrode side of the battery 5 and the capacitor 14 via the negative electrode terminal 22.

The power semiconductor device 1 of the present embodiment is a 2-in-1 structure which is a structure in which two arm circuits of an upper arm circuit and a lower arm circuit are integrated into one module. When a 3-in-1 structure, a 4-in-1 structure, a 6-in-1 structure, or the like other than the 2-in-1 structure is used, the power semiconductor device can be miniaturized. The upper arm circuit includes the upper arm IGBT 10U and the upper arm diode 11U as the power semiconductor elements for switching, and the lower arm circuit includes the lower arm IGBT 10L and the lower arm diode 11L.

As illustrated in FIG. 2(b), an electric system including the power conversion device is provided with a plurality of power semiconductor circuit sections 2, the plurality of capacitors 14, a motor 4, and the battery 5.

The IGBT receives a drive signal and performs a switching operation to convert DC power supplied from the battery 5 into three-phase AC power. If an L-component (inductance) between the power semiconductor element and the capacitor 14 is reduced, a surge voltage can be suppressed so that a withstand voltage is improved. When changing from 2-in-1 to 6-in-1, the capacitor capacity of the power semiconductor device increases since the capacitors 14 are connected in parallel.

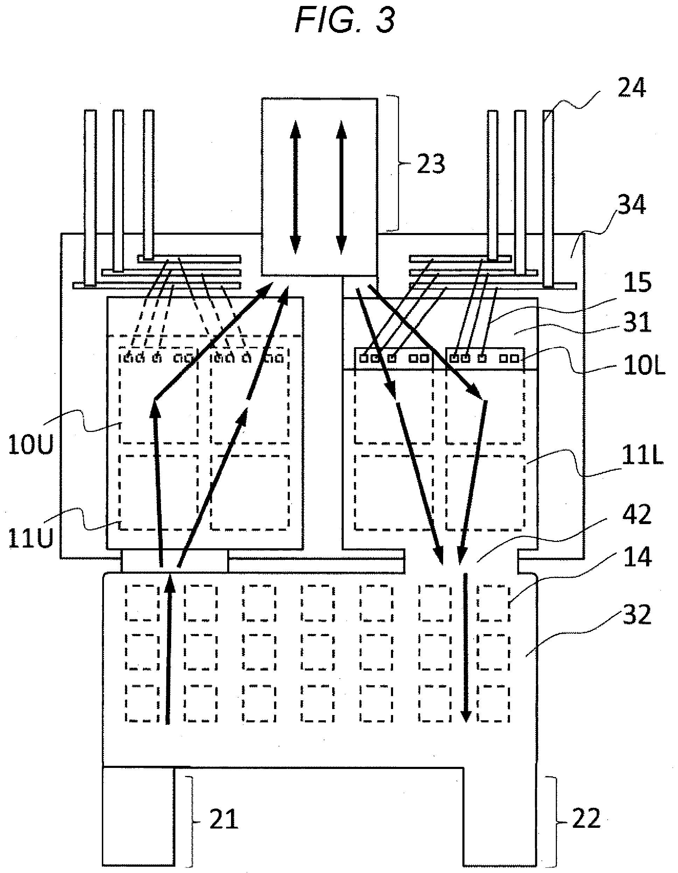

FIG. 3 is a perspective plan view of the power semiconductor device 1 illustrating an arrangement of the power semiconductor element and the capacitors 14 obtained by removing the sealing member 13 and the emitter-side ceramic substrate 36 and being seen through the positive electrode conductor portion 31 and the negative electrode conductor portion 32.

Arrows illustrated in FIG. 3 indicate the flow of current through the power semiconductor element to the positive electrode terminal 21 and the negative electrode terminal 22.

As illustrated in FIGS. 4 and 5, the plurality of capacitors 14 are arranged such that an array direction of a positive-electrode-side electrode and a negative-electrode-side electrode of the capacitor 14 is parallel to an array direction of an emitter electrode and a collector electrode of the upper arm IGBT 10U.

Exposed portions of the metallized portion 35 and the metallized portion 38 illustrated in FIGS. 1(a) and 1(b) radiate heat of the power semiconductor element, the positive electrode conductor portion 31, the negative electrode conductor portion 32, and the capacitor 14.

As illustrated in FIGS. 4 and 5, the power semiconductor circuit section 2 is formed of the emitter-side ceramic substrate 36, a part of the negative electrode conductor portion 32, an IGBT and a diode, a part of the positive electrode conductor portion 31, and the collector-side ceramic substrate 33.

The emitter-side ceramic substrate 36 is formed of the metallized portion 38 that forms a heat radiation surface between the IGBT 10L and the diode 11L and a metal circuit section 37 connected to the negative electrode conductor portion 32 and the AC output terminal 23 via a solder 12.

The collector-side ceramic substrate 33 is formed of the metallized portion 35 that forms a heat radiation surface between the IGBT 10L and the diode 11L and a metal circuit section 34 connected to the positive electrode conductor portion 31, the AC output terminal 23, and the control terminal 24 via the solder 12.

A bonding wire 15 is a wiring that connects the metal circuit section 34 connected to the control terminal 24 and a control electrode of the IGBT 10L, and is made of AI or the like. In addition, the solder 12 is assumed to be a bonding material obtained by melting and solidifying metal, and a bonding member such as a sintered material may be used. There is an effect of improving the yield and assembling property by using the sintered material as the bonding member.

As illustrated in FIGS. 4 and 5, the capacitor circuit section 3 is formed of a part of the negative electrode conductor portion 32, the plurality of capacitors 14, and a part of the positive electrode conductor portion 31. A vent portion 42 of the positive electrode conductor portion 31 is formed between the capacitor circuit section 3 and the power semiconductor circuit section 2.

As illustrated in FIG. 4, the vent portion 42 formed in the positive electrode conductor portion 31 has an angle so as to be inclined with respect to a surface parallel to the array direction of the plurality of capacitors 14. As a result, the power semiconductor device 1 can be easily adjusted to a size of the discrete capacitors, which contributes to suppressing an increase in size of the power semiconductor device 1 while improving the assembling property.

Here, a surface of the metallized portion 38 exposed from the sealing member 13 is defined as a first exposure surface, and a surface of the metallized portion 35 exposed from the sealing member 13 is defined as a second exposure surface. Further, a plane with which the first exposure surface overlaps is defined as a first plane F1, and a plane with which the second exposure surface overlaps is defined as a second plane F2.

The capacitor circuit section 3 according to the present embodiment is formed to be smaller than a space between the first plane F1 and the second plane F2. Further, the positive electrode conductor portion 31 and the negative electrode conductor portion 32 form a concave portion 41 configured to accommodate a part of each of the capacitors 14.

This contributes to suppressing an increase in size of the capacitor circuit section 3 in the height direction and suppressing the increase in size of the power semiconductor device 1. Incidentally, the concave portion 41 may be formed in either the positive electrode conductor portion 31 or the negative electrode conductor portion 32.

Since the distance between the positive electrode conductor portion 31 and the negative electrode conductor portion 32 can be changed in the vent portion 42, the degree of freedom in design for mounting the capacitor 14 increases, and the discrete capacitors can be used.

In addition, no capacitor is arranged between the power semiconductor elements, and thus, the limit on the number of capacitors that can be used per power semiconductor device is reduced. Since the concave portion 41 is provided in the positive electrode conductor portion 31 or the negative electrode conductor portion 32, the distance between the positive electrode conductor portion 31 and the negative electrode conductor portion 32 is narrowed to reduce an inductance, the surge voltage decreases, and the withstand voltage is improved. The concave portion 41 facilitates positioning and mounting of the capacitor 14. When assembling the capacitor 14 with the bonding material such as the solder, a jig for positioning the capacitor is not required.

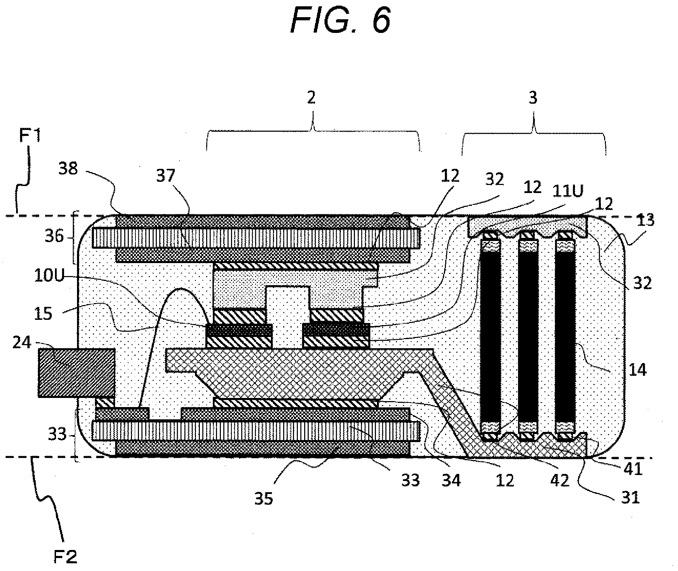

FIG. 6 is a cross-sectional view of a power semiconductor device according to another embodiment.

The capacitor circuit section 3 according to the present embodiment includes the negative electrode conductor portion 32 that overlaps with the first plane F1 and is exposed from the sealing member 13, and the positive electrode conductor portion 31 that overlaps with the second plane F2 and is exposed from the sealing member 13. Further, the positive electrode conductor portion 31 and the negative electrode conductor portion 32 form a concave portion 41 configured to accommodate a part of each of the capacitors 14. As a result, the cooling performance of the capacitor circuit section 3 is improved.

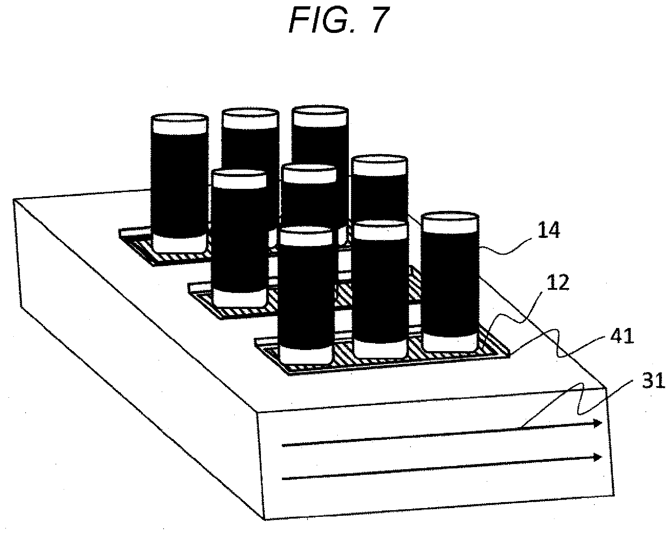

FIG. 7 is a perspective view illustrating a modification when the plurality of capacitors 14 are accommodated in the concave portions 41 formed in the positive electrode conductor portion 31.

Arrows illustrated in FIG. 7 indicate the flow of current. In the present embodiment, the concave portion 41 has a longitudinal direction formed along an array of the plurality of capacitors 14 and a lateral direction formed in a direction perpendicular to the array direction.

Then, a wiring inductance is reduced by arranging the concave portion 41 such that the longitudinal direction is parallel to the flow of current. In addition, it becomes easier to accommodate the bonding material such as the solder and the sintered material as the area of the concave portion 41 increases, so that the assembling property is improved.

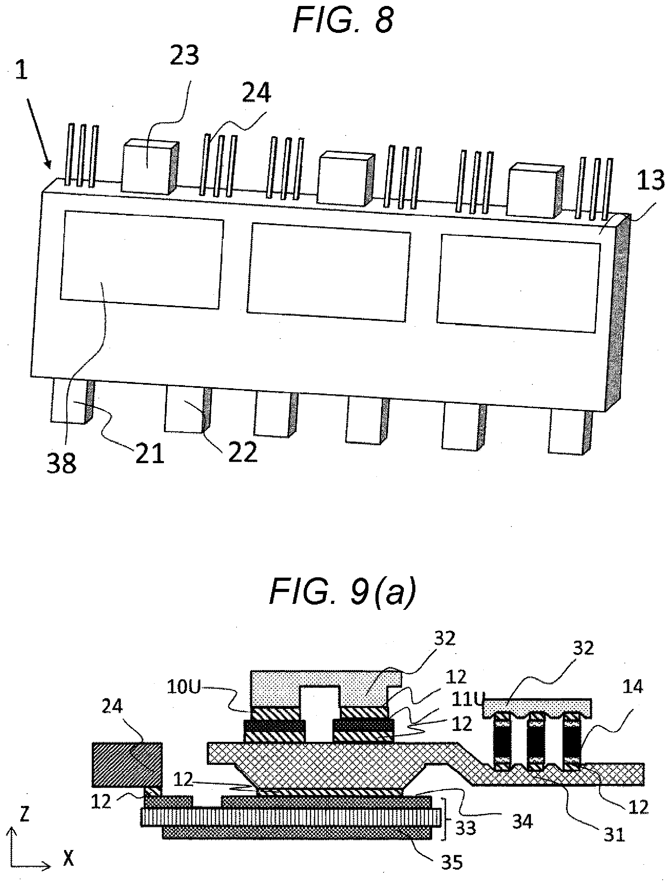

FIG. 8 is an overall perspective view of a 6-in-1 power semiconductor device formed by combining the 2-in-1 power semiconductor devices 1 illustrated in FIGS. 1 to 7.

Here, 2-in-1 refers to a structure in which one power semiconductor device wrapped by a sealing member is regarded as one module, and two circuit units of an upper arm and a lower arm are built in the one module. That is, 6-in-1 has three upper arms and three lower arms in one power semiconductor device. With the integration from 2-in-1 to 6-in-1, the power semiconductor device can be miniaturized.

FIGS. 9(a) to 9(d) are cross-sectional views illustrating a manufacturing process of the power semiconductor device 1.

As illustrated in FIG. 9(a), terminals such as the positive electrode conductor portion 31 and the control terminal 24 are mounted on the metal circuit section 34 of the collector-side ceramic substrate via the solder 12. Incidentally, the solder 12 may be made of a sintered material or the like.

The power semiconductor elements are mounted on the positive electrode conductor portion 31 via the solder 12, and the capacitors 14 are mounted on the concave portions 41 of the positive electrode conductor portion 31. Further, the negative electrode side conductor 32 is mounted and connected to an emitter electrode surface of the power semiconductor element and the capacitor 14 via the solder 12.

The positive electrode conductor portion 31 and the negative electrode conductor portion 32 are not particularly limited as long as being metal materials having electrical conductivity, but copper having high electrical conductivity is desirably used. Aluminum may be used for weight reduction and cost reduction.

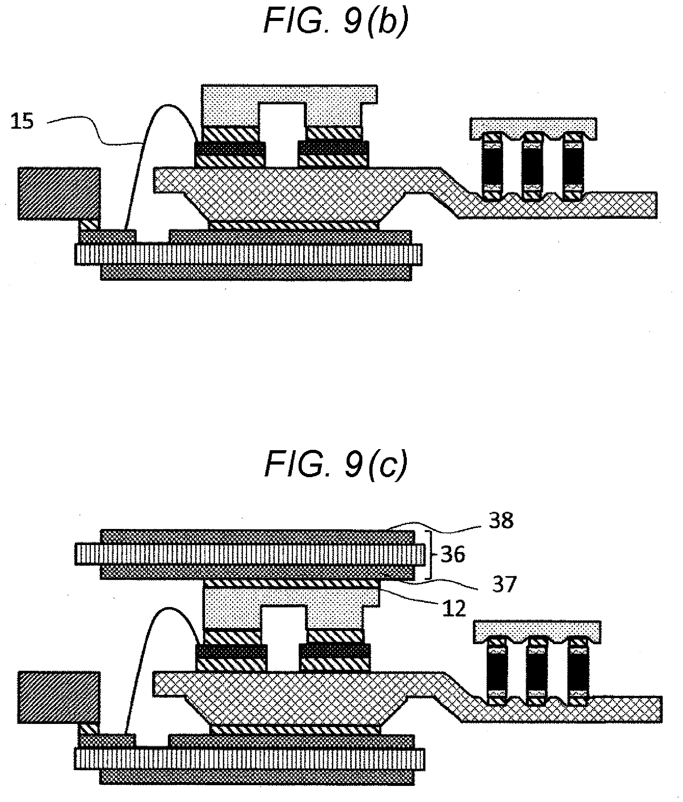

As illustrated in FIG. 9(b), the Al wire bonding 15 is connected between the upper arm IGBT 10U and the lower arm IGBT 10L, and the metal circuit section 34 of the ceramic substrate.

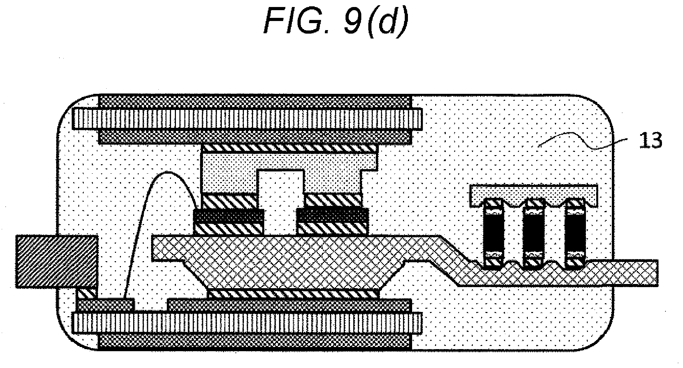

As illustrated in FIG. 9, the emitter-side ceramic substrate 36 is mounted on the negative electrode conductor portion 32 via the solder 12.

As illustrated in FIG. 9(d), a transfer mold is used to perform sealing using resin, thereby forming a transfer mold portion that functions as the sealing member 13. When the capacitor 14 is arranged between and close to the positive electrode terminal 21 and the negative electrode terminal 22, the inductance is reduced, but the insulating property deteriorates. It is desirable to seal all the capacitors 14 collectively in order to ensure the insulating property.

### Reference Signs List

- 1: power semiconductor device
- 2: power semiconductor circuit section
- 3: capacitor circuit section
- 4: motor
- 5: battery
- 10U: upper arm IGBT
- 10L: lower arm IGBT
- 11U: upper arm diode
- 11L: lower arm diode
- 12: solder
- 13: sealing member
- 14: capacitor
- 15: bonding wire
- 21: positive electrode terminal
- 22: negative electrode terminal
- 23: AC output terminal
- 24: control terminal
- 31: positive electrode conductor portion
- 32: negative electrode conductor portion
- 33: collector-side ceramic substrate
- 34: metal circuit section of collector-side ceramic substrate
- 35: metallized portion of collector-side ceramic substrate
- 36: emitter-side ceramic substrate
- 37: metal circuit section of emitter-side ceramic substrate
- 38: metallized portion of emitter-side ceramic substrate
- 41: concave portion
- 42: vent portion
- F1: first plane
- F2: second plane

## Claims

1. A power semiconductor device comprising:
a power semiconductor circuit section;
a plurality of smoothing capacitors;
a positive electrode conductor portion and a negative electrode conductor portion connecting the power semiconductor circuit section and the plurality of smoothing capacitors; and
a sealing material that seals the power semiconductor circuit section, the plurality of smoothing capacitors, the positive electrode conductor portion, and the negative electrode conductor portion,
wherein the plurality of smoothing capacitors form a capacitor circuit section sandwiched between the positive electrode conductor portion and the negative electrode conductor portion,
the power semiconductor circuit section has a first exposure surface exposed from the sealing material and a second exposure surface that is exposed from the sealing material and provided on a side opposite to the first exposure surface,
a plane with which the first exposure surface overlaps is defined as a first plane, and a plane with which the second exposure surface overlaps is defined as a second plane,
the capacitor circuit section is formed so as to fit in a space between the first plane and the second plane, and
the positive electrode conductor portion or the negative electrode conductor portion forms a concave portion to accommodate a part of each of the plurality of smoothing capacitors.

2. The power semiconductor device according to claim 1, wherein
the capacitor circuit section is formed so as to be smaller than the space between the first plane and the second plane.

3. The power semiconductor device according to claim 1 or 2, wherein
the positive electrode conductor portion or the negative electrode conductor portion has an inclined portion that is provided between the power semiconductor circuit section and the capacitor circuit section and formed so as to have an angle with respect to an array direction of the plurality of smoothing capacitors.

4. The power semiconductor device according to any one of claims 1 to 3, wherein
the smoothing capacitor is arranged such that a longitudinal direction of the smoothing capacitor is perpendicular to an electrode surface of a semiconductor element, and is arranged in a space sandwiched between the positive electrode conductor portion and the negative electrode conductor portion.

## Patentansprüche

1. Leistungshalbleitervorrichtung, die Folgendes umfasst:
einen Leistungshalbleiterschaltungsteil;
eine Vielzahl von Glättungskondensatoren;
einen Leiterabschnitt mit positiver Elektrode und einen Leiterabschnitt mit negativer Elektrode, die den Leistungshalbleiterschaltungsteil und die Vielzahl von Glättungskondensatoren verbinden; und
ein Versiegelungsmaterial, das den Leistungshalbleiterschaltungsteil, die Vielzahl von Glättungskondensatoren, den Leiterabschnitt mit positiver Elektrode und den Leiterabschnitt mit negativer Elektrode versiegelt,
wobei die Vielzahl von Glättungskondensatoren einen Kondensatorschaltungsteil ausbilden, der sandwichartig zwischen dem Leiterabschnitt mit positiver Elektrode und dem Leiterabschnitt mit negativer Elektrode eingefügt ist,
wobei der Leistungshalbleiterschaltungsteil eine erste Freilegungsfläche, die von dem Versiegelungsmaterial freigelegt ist, und eine zweite Freilegungsfläche, die von dem Versiegelungsmaterial freigelegt ist und auf einer zu der ersten Freilegungsfläche entgegengesetzten Seite bereitgestellt ist, umfasst,
wobei eine Ebene, mit der die erste Freilegungsfläche überlappt, als erste Ebene definiert ist und eine Ebene, mit der die zweite Freilegungsfläche überlappt, als zweite Ebene definiert ist,
der Kondensatorschaltungsteil so ausgebildet ist, dass er in einen Raum zwischen der ersten Ebene und der zweiten Ebene passt, und
der Leiterabschnitt mit positiver Elektrode oder der Leiterabschnitt mit negativer Elektrode einen konkaven Abschnitt ausbildet, um einen Teil von jedem aus der Vielzahl von Glättungskondensatoren aufzunehmen.

2. Leistungshalbleitervorrichtung nach Anspruch 1, wobei der Kondensatorschaltungsteil so ausgebildet ist, dass er kleiner als der Raum zwischen der ersten Ebene und der zweiten Ebene ist.

3. Leistungshalbleitervorrichtung nach Anspruch 1 oder 2, wobei der Leiterabschnitt mit positiver Elektrode oder der Leiterabschnitt mit negativer Elektrode einen geneigten Abschnitt aufweist, der zwischen dem Leistungshalbleiterschaltungsteil und dem Kondensatorschaltungsteil bereitgestellt ist und so ausgebildet ist, dass er in Bezug auf eine Anordnungsrichtung der Vielzahl von Glättungskondensatoren einen Winkel aufweist.

4. Leistungshalbleitervorrichtung nach einem der Ansprüche 1 bis 3, wobei der Glättungskondensator so angeordnet ist, dass die Längsrichtung des Glättungskondensators normal auf eine Elektrodenfläche eines Halbleiterelements steht, und in einem Raum angeordnet ist, der sandwichartig zwischen dem Leiterabschnitt mit positiver Elektrode und dem Leiterabschnitt mit negativer Elektrode eingefügt ist.

## Revendications

1. Dispositif à semi-conducteur de puissance, comprenant :
une section de circuit à semi-conducteur de puissance ;
une pluralité de condensateurs de lissage ;
une partie de conducteur d'électrode positive et une partie de conducteur d'électrode négative connectant la section de circuit à semi-conducteur de puissance et la pluralité de condensateurs de lissage ; et
un matériau d'étanchéité qui rend étanche la section de circuit à semi-conducteur de puissance, la pluralité de condensateurs de lissage, la partie de conducteur d'électrode positive et la partie de conducteur d'électrode négative,
dans lequel la pluralité de condensateurs de lissage forment une section de circuit à condensateur enserrée entre la partie de conducteur d'électrode positive et la partie de conducteur d'électrode négative,
la section de circuit à semi-conducteur de puissance présente une première surface d'exposition qui est exposée à partir du matériau d'étanchéité et une seconde surface d'exposition qui est exposée à partir du matériau d'étanchéité et qui est prévue sur un côté opposé à la première surface d'exposition,
un plan de chevauchement avec la première surface d'exposition est défini comme un premier plan, et un plan de chevauchement avec la seconde surface d'exposition est défini comme un second plan,
la section de circuit à condensateur est formée de manière à être placée dans un espace entre le premier plan et le second plan, et
la partie de conducteur d'électrode positive ou la partie de conducteur d'électrode négative forme une partie concave pour recevoir une partie de chacun de la pluralité de condensateurs de lissage.

2. Dispositif à semi-conducteur de puissance selon la revendication 1, dans lequel
la section de circuit à condensateur est formée de manière à être plus petite que l'espace entre le premier plan et le second plan.

3. Dispositif à semi-conducteur de puissance (21, 27) selon la revendication 1 ou 2, dans lequel
la partie de conducteur d'électrode positive ou la partie de conducteur d'électrode négative présente une partie inclinée qui est prévue entre la section de circuit à semi-conducteur de puissance et la section de circuit à condensateur et est formée de manière à avoir un angle par rapport à une direction de réseau de la pluralité de condensateurs de lissage.

4. Dispositif à semi-conducteur de puissance selon l'une quelconque des revendications 1 à 3, dans lequel
le condensateur de lissage est agencé de telle sorte qu'une direction longitudinale du condensateur de lissage est perpendiculaire à une surface d'électrode d'un élément semi-conducteur, et est agencé dans un espace enserré entre la partie de conducteur d'électrode positive et la partie de conducteur d'électrode négative.
